(19) Europäisches Patentamt
European Patent Office
Office européen des brevets

(11) **EP 4 488 757 A1**

(12) **EUROPEAN PATENT APPLICATION**

(43) Date of publication:
**08.01.2025 Bulletin 2025/02**

(21) Application number: **23182989.6**

(22) Date of filing: **03.07.2023**

(51) International Patent Classification (IPC):
**G03F 7/20** (2006.01)

(52) Cooperative Patent Classification (CPC):
**G03F 7/70633**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **WERKMAN, Roy**
**5500 AH Veldhoven (NL)**
• **HAUPTMANN, Marc**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHODS OF METROLOGY RELATED TO OVERLAY**

(57) A metrology method comprises obtaining a first absolute position metric of a first structure in a first layer on a substrate and a second absolute position metric of a second structure in a second layer of the substrate; and determining from first absolute position metric and said second absolute position metric one or more of: an exposure induced first layer pattern displacement describing a displacement error of said first structure resultant from exposure of the structure, an exposure induced second layer pattern displacement describing a displacement error of said second structure resultant from exposure of the structure, a process induced first layer pattern displacement describing a displacement error of said first structure resultant from processing of the structure and/or an alignment error describing an error in alignment data used to align the second layer to the first layer.

Fig. 4

## Description

BACKGROUND

Field of the Invention

**0001** The present invention relates to control apparatus and control methods usable, for example, to maintain performance in the manufacture of devices by patterning processes such as lithography. The invention further relates to methods of manufacturing devices using lithographic techniques. The invention yet further relates to computer program products for use in implementing such methods.

Related Art

**0002** A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

**0003** Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself.

**0004** Alignment is typically measured using an alignment sensor within the lithographic apparatus. The alignment sensor measures positional information (alignment data) of periodic structures or alignment marks, such that an alignment model can be fitted to this alignment data. The alignment metrology may be applied sequentially with exposure (e.g., where the lithographic apparatus has only a single stage for (alignment) measurement and for exposure, or at least partially simultaneously (e.g., where the lithographic apparatus has separate measure and exposure stages).

**0005** It is also known to perform alignment metrology using a standalone alignment station. Such standalone alignment metrology may be performed inline (e.g., prior to each wafer exposure) and/or offline (e.g., on a subset of the exposed wafers).

**0006** In such lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

**0007** The manufacturing processes may be for example lithography, etching, deposition, chemical mechanical planarization, oxidation, ion implantation, diffusion or a combination of two or more of them.

**0008** Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

**0009** In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

**0010** Conventional overlay metrology measures a relative offset between structures (e.g., overlay sub-structures typically forming an overlay structure or overlay target). Such a relative measurement does not allow individual contributions to overlay (e.g., due to alignment error, exposure errors and/or processing errors) to be disentangled and separately quantified. This leads to sub-optimal correction and/or control strategies.

**0011** It would be desirable to improve such overlay metrology methods.

SUMMARY OF THE INVENTION

**0012** According to a first aspect of the present invention there is provided a method of metrology comprising obtaining a first absolute position metric of a first structure in a first layer on a substrate and a second absolute position metric of a second structure in a second layer of the substrate, the first layer being below the second layer; obtaining first layer shape data describing a shape of the first layer; and determining from said first layer shape data, first absolute position metric and said second absolute position metric one or more of: an exposure induced first layer pattern displacement describing a displacement error of said first structure resultant from exposure of the structure, an exposure induced second layer pattern displacement describing a displacement error of said second structure resultant from exposure of the structure, a process induced first layer pattern displacement describing a displacement error of said first structure resultant from processing of the structure and/or an alignment error describing an error in alignment data used to align the second layer to the first layer.

**0013** According to a second aspect of the present invention there is provided a computer program product containing one or more sequences of machine-readable instructions for implementing calculating steps in a method according to the first aspect of the invention as set forth above

**0014** The invention yet further provides a processing arrangement and lithographic apparatus comprising the computer program of the second aspect.

**0015** These and other aspects and advantages of the apparatus and methods disclosed herein will be appreciated from a consideration of the following description and drawings of exemplary embodiments.

BRIEF DESCRIPTION OF THE DRAWINGS

**0016** Embodiments of the invention will now be described, by way of example only, with reference to the accompanying schematic drawings in which corresponding reference symbols indicate corresponding parts, and in which:

Figure 1 depicts a lithographic apparatus suitable for use in an embodiment of the present invention;
Figure 2 depicts a lithographic cell or cluster in which an inspection apparatus according to the present invention may be used;
Figure 3 illustrates schematically measurement and exposure processes in the apparatus of Figure 1, according to known practice;
Figure 4 is an illustration of structures in two layers, illustrating the various effects which contribute to overlay in a direct alignment example;
Figure 5 is an illustration of structures in two layers, illustrating the various effects which contribute to overlay in an indirect alignment example; and
Figure 6 is a flow diagram of determining whether deformation described by foundation layer metrology data is correctable according to an embodiment.

DETAILED DESCRIPTION OF EXEMPLARY EMBODIMENTS

**0017** Before describing embodiments of the invention in detail, it is instructive to present an example environment in which embodiments of the present invention may be implemented.

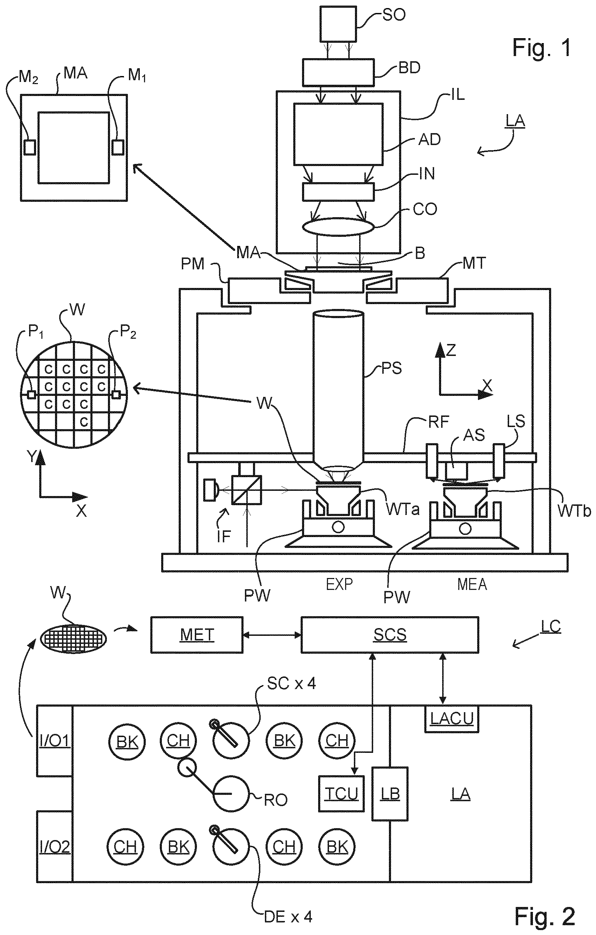

**0018** Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables WTa and WTb (e.g., a substrate support or substrate/wafer table), each comprising a plurality of burls on a support surface and each constructed to hold a substrate (e.g., a resist coated wafer) W; and a projection system (e.g., a refractive projection lens system) PS configured to project a pattern imparted to the radiation beam B by patterning device MA onto a target portion C (e.g., including one or more dies) of the substrate W. Each substrate table may be connected to a second positioner PW configured to accurately position the substrate in accordance with certain parameters. A reference frame RF connects the various components, and serves as a reference for setting and measuring positions of the patterning device and substrate and of features on them.

**0019** The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

**0020** The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

0021 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0022 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0023 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0024 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0025 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0026 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0027 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

0028 Patterning device (e.g., mask) MA and substrate W may be aligned using mask alignment structures or alignment marks M1, M2 and substrate alignment structures or alignment marks P1, P2. Although the substrate alignment structures as illustrated occupy dedicated target portions, they may be located in spaces between target portions (these are known as scribe-lane alignment structures). Similarly, in situations in which more than one die is provided on the patterning device (e.g., mask) MA, the mask alignment structures may be located between the dies. Small alignment structures may also be included within dies, in amongst the device features, in which case it is desirable that the markers be as small as possible and not require any different imaging or process conditions than adjacent features. The alignment system, which detects the alignment structures, is described further below.

0029 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

0030 Combinations and/or variations on the above described modes of use or entirely different modes of use may also be employed.

0031 Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment structures on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

0032 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0033 In order that the substrates that are exposed by the lithographic apparatus are exposed correctly and consistently, it is desirable to inspect exposed substrates to measure properties such as overlay between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

0034 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0035 The metrology step with metrology system MET can also be done after the resist pattern has been etched into a product layer. The latter possibility limits the possibilities for rework of faulty substrates but may provide additional information about the performance of the manufacturing process as a whole.

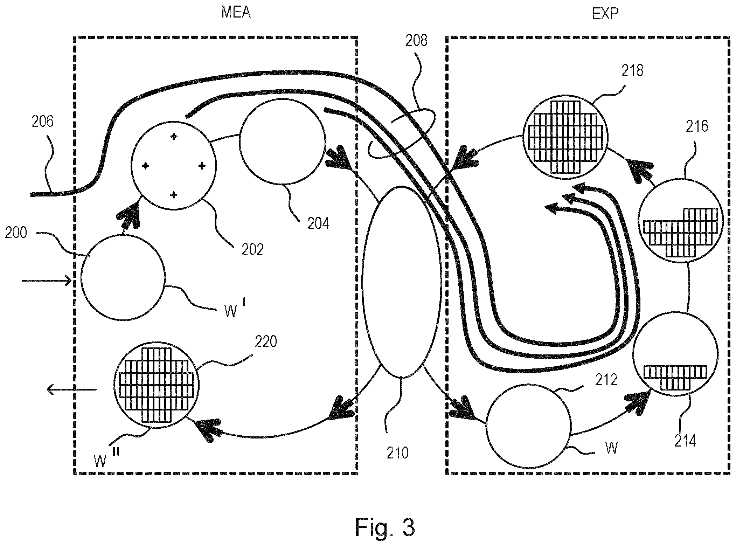

0036 Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of lithographic apparatus, for example those having a single substrate stage and a docking metrology stage.

0037 On the left hand side within a dotted box are steps performed at measurement station MEA, while the right hand side shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

0038 Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

0039 The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated lithographic apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

0040 At 202, alignment measurements using the substrate marks P1 etc. and image sensors (not shown) are used to measure and record alignment of the substrate relative to substrate table WTa/WTb. In addition, several alignment structures across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

0041 At step 204, a map of substrate height (Z) against X-Y position is measured also using the level sensor LS. Primarily, the height map is used only to achieve accurate focusing of the exposed pattern. It may be used for other purposes in addition.

0042 When substrate W' was loaded, recipe data 206 were received, defining the exposures to be performed, and also properties of the substrate and the patterns previously made and to be made upon it. Where there is a choice of alignment structures on the substrate, and where there is a choice of settings of an alignment sensor, these choices are defined in an alignment recipe among the recipe data 206. The alignment recipe therefore defines how positions of alignment structures are to be measured, as well as which marks.

0043 At 210, substrates W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment structures M1, M2. In steps 214, 216, 218, scanning motions and radiation pulses are applied at successive target locations across the substrate W, in order to complete the exposure of a number of patterns.

0044 By using the alignment data and height map obtained at the measuring station in the performance of the exposure steps, these patterns are accurately aligned with respect to the desired locations, and, in particular, with respect to features previously laid down on the same substrate (i.e., to ensure good overlay performance). The exposed substrate, now labeled W" is unloaded from the apparatus at step 220, to undergo etching or other processes, in accordance with the exposed pattern.

0045 To monitor whether overlay is within specification and provide process control corrections, overlay metrology may be performed on the exposed structures (e.g., on proxy structures such as overlay structures (overlay targets), although overlay metrology can be performed directly on functional product structures). Typically overlay is measured as a relative displacement between structures in respective different layers, rather than measuring the absolute positions of these structures. This is typically simpler and/or faster to do. For example, diffraction based overlay (DBO) techniques may use a target comprising periodic structures or gratings in the respective layers which diffract incident measurement radiation.

0046 In the absence of overlay error (and assuming a perfect target), a DBO target will be symmetrical and the incident measurement radiation will be diffracted equally into each of a pair of complementary diffraction orders, such that when measured they each have the same intensity (or other suitable measurement parameter). Any overlay will result in the diffraction orders being imbalanced. As such, the overlay may be determined from a determination of this imbalance (e.g., in terms of an intensity difference in the +1 and -1 diffraction orders). In practical implementations, pairs of biased DBO targets may be used to, e.g., to help distinguish overlay from other asymmetries in the target.

0047 An alternative or complementary overlay metrology method comprises image based overlay (IBO). This method typically measures the relative position of structures in respective different layers using imaging techniques. IBO targets may, for example, comprise box-in-box structures, gratings (spatially separated in the substrate plane) or any other suitable structure. It can be appreciated that as IBO targets do not relay on diffraction, gratings/periodic structures are not required.

0048 It is known to perform alignment training based on such overlay metrology (comprising relative overlay measurements). Such alignment training may optimize an alignment model such that correlation between alignment data and overlay (post alignment) is minimized. This may be done to minimize the impact of alignment structure (alignment mark) deformation, for example. An example of such a method is that sometimes referred to as WAMM (wafer alignment model mapping), which is described in more detail in PCT publications WO 2019001871 and WO 2017060054, each incorporated herein by reference. In such alignment training, use of relative overlay induces an inaccuracy via alignment error and/or bottom layer exposure and processing error.

0049 Because the overlay measurements are relative, it is not possible to disentangle different overlay contributors such as contributions due to alignment errors and contributions due to processing (e.g., one or more processing steps typically performed post exposure, such as etch, polishing etc.). However, for more optimal process control/corrections, it would be advantageous to be able to quantify the individual overlay contributors, e.g., such that process corrections could be implemented at the appropriate time and/or within the appropriate apparatus. For example, alignment errors are more properly addressed during alignment metrology and/or modeling (pre-exposure), while processing induced errors may be better addressed via control of a processing apparatus (e.g., such as an etcher) when possible, or via control of the exposure in a manner more optimal for minimizing processing effects.

0050 In addition, photonic model training based on relative overlay metrology does not allow for separation of non-orthogonal effects in the two layers, resulting in the model being less accurate. For example, in the case of substrate/wafer heating, disentangling heating effects during exposure of the respective layers is impossible or difficult, particularly if the exposure routing is the same.

0051 Machine drift control using on-product overlay is not possible, as the machine drift is present in both layers of a relative overlay measurement, but originating from different time periods (depending on the processing delay between layers).

0052 Methods have been described for measuring overlay in absolute terms, e.g., via absolute position measurements of a structure (e.g., overlay substructures which together form an overlay structure or overlay target) in respective layers. For example, in Lee et al, "Absolute alignment measurement of underlayer and overlayer of diffraction-based overlay mark by image-based alignment metrology system", SPIE Advanced Lithography 2023 Paper 12496-81 (incorporated herein by reference), a method of absolute overlay metrology is described using a standalone alignment station (e.g., an image-based alignment station).

0053 Lee *et al* describes using an image based standalone alignment station to measure an IBO overlay structure in two overlapping layers, by masking (in an image processing step, rather than physically) respectively the first layer and second layer when determining position. That is, the top structure absolute position can be determined with the bottom structure masked using image processing and *vice versa*. If the target is a DBO overlay structure (i.e., with the structures overlapping in the z direction. perpendicular to the substrate plane), than a stacked mark measurement function may be used to split the overlay error of each layer to respectively to each grid error, from snapshots captured by the standalone alignment station and/or a scanning electron microscope/e-beam tool.

0054 The concepts herein may use the same or similar methods and standalone alignment station as that disclosed on the aforementioned Lee *et al* paper. However, it can be appreciated that this is not a requirement, and any method and/or tool suitable for measurement of absolute position of structures in different layers, and therefore overlay, may be used, including for example a scanning electron microscope/e-beam tool or transmission electron microscope.

0055 In a first embodiment, it is proposed to build on the possibility to measure absolute position per layer and therefore the absolute shape of each layer, by performing a processing step on this absolute position data to determine individually one or both of an alignment error contribution of the overlay error and a processing contribution of the alignment error. As such a method may comprise measuring a first absolute position metric of a first structure in a first layer on a substrate and a second absolute position metric of a second structure in a second layer of the substrate, the first layer being below the second layer. The method further comprises determining from said first absolute position metric and said second absolute position metric (e.g., in addition to overlay) one or more of: an exposure induced first layer pattern displacement describing a displacement error of said first structure resultant from exposure of the structure, an exposure induced second layer pattern displacement describing a displacement error of said second structure resultant from exposure of the structure, a process induced first layer pattern displacement describing a displacement error of said first structure resultant from processing of the structure and/or a first layer alignment error describing an error in alignment data used to align the second layer to the first layer.

0056 In the context of this disclosure, relative overlay is the difference in position between the first structure and the second structure (or more generally between two structures in different layers). Absolute position may be defined as the position of a structure with respect to an expected position as defined by the wafer grid (e.g., as calibrated through wafer alignment).

0057 Two different variations on this first embodiment will be described. A first variation is in the context of direct alignment. This describes the situation where, when overlay is being determined between a first layer and a second layer (the second layer, e.g., topmost layer, being exposed subsequent to the first layer), the second layer is directly aligned to the first layer. In other words, the alignment structures in the first layer are measured and used for positioning of the second layer. A second variation is in the context of indirect alignment, where the first layer and second layer are each aligned to a common different lower layer.

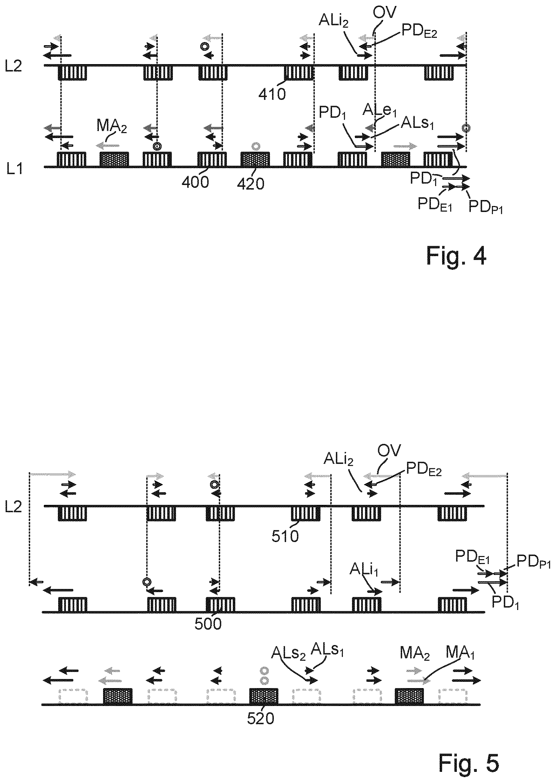

0058 Figure 4 illustrates the concept of direct alignment, where first layer structures 400 are formed in a first layer L1 and second layer structures 410 are formed in a second layer L2. The second layer structures and first layer structures may together comprise overlay structures, for example. First layer L1 also comprises alignment structures 420 which were formed (and used) for aligning the exposure of second layer L2 to the first layer L1; e.g., to minimize overlay error (maximize overlay) or other positional parameter of interest such as edge placement error. It can be appreciated that, while no intervening layers are shown between the first layer and second layer, this is optionally possible within the scope of this disclosure.

0059 Also shown in the figure are the various contributions to (local) overlay OV. These include a first layer pattern displacement $PD_1$, which describes the absolute position error of the layer one structures 400, resulting from exposure error and process error. As such, this first layer pattern displacement $PD_1$ comprises a combination or sum of exposure induced first layer pattern displacement $PD_{E1}$ and process induced first layer pattern displacement $PD_{P1}$. Other first layer overlay contributors comprise the first layer shape data $ALs_1$ determined from alignment data. For example, the first layer shape data $ALs_1$ may be determined from a model fitting to second layer measured alignment data $MA_2$ as measured from the alignment structures 420 in the first layer, in preparation for second layer exposure to align the second layer to the first layer.

0060 As such, the first layer shape data may comprise the fitted alignment model, having been fitted to the marks in the first/lower layer, for aligning the second/upper layer to this first layer, such that the first layer shape data describes the shape of this first layer.

0061 A first layer alignment error $ALe_1$, describing an error in aligning the second layer to the first layer (e.g., due to *inter alia* alignment structure deformation or modeling errors), may comprise a difference of the first layer shape data $ALs_1$ and first layer pattern displacement $PD_1$. Also shown is an exposure induced second layer pattern displacement $PD_{E2}$, which assumes in this example that the second layer structures 400 have not yet been processed and therefore not yet subject to a process induced second layer pattern displacement (after processing/after-etch second layer metrology is also possible). In addition, a second layer alignment induced shape $ALi_2$ may be resultant from *inter alia* alignment structure deformation or modeling errors of the alignment structures 420 and/or measurements thereof.

0062 Overlay OV (e.g., as determined via after development inspection ADI as measured prior to processing steps to the second/last exposed layer, such as etching) comprises a difference between the second absolute position metric relating to the second structure in the second layer and the first absolute position metric relating to the first structure in the first layer. The first absolute position metric comprises the first layer pattern displacement $PD_1$ and the second absolute position metric comprises a combination or sum of the exposure induced second layer pattern displacement $PD_{E2}$ and second layer alignment induced shape $ALi_2$. As such, a direct alignment conventional relative overlay measurement yields:

$$OV = (ALi_2 + PD_{E2}) - PD_1 \qquad Eq1$$

Note that the second absolute position metric will comprise second layer pattern displacement $PD_2$ (i.e., with both exposure induced and processing induced components) if the metrology is performed after-etch (e.g., after-etch inspection AEI). It can also be appreciated that AEI metrology may be performed in addition to ADI metrology. If this is the case, then both ADI and AEI metrology data is available, and therefore the difference of this data may be used to determine the processing (i.e., process induced second layer pattern displacement $PDr_2$).

0063 In addition, (e.g., conventional) alignment metrology will still be performed prior to the second layer exposure, which will yield the first layer shape data $ALs_1$. This first layer shape data $ALs_1$ may induce, and therefore be equal to, the second layer alignment induced shape $ALi_2$.

0064 Such conventional metrology therefore does not allow for individual determination of first layer

alignment error $Ale_1$, second layer (exposure induced) pattern displacement $PD_{E2}$, nor the first layer pattern displacement $PD_1$ (and its individual expose and process contributions). As such, it is proposed to perform absolute position metrology to individually determine pattern displacement for first layer structures and for second layer structures. Based on this, one or more of these parameters can be individually quantified.

**0065** According to an embodiment, the first layer metrology will yield first layer pattern displacement $PD_1$ (first absolute position metric) and the second layer metrology will yield the sum $ALi_2 + PD_{E2}$ (second absolute position metric) of the exposure induced second layer pattern displacement $PD_{E2}$ and second layer alignment induced shape $ALi_2$. The first layer metrology and second layer metrology may be performed together, e.g., using the methods described in the aforementioned Lee *et. al.* paper. As before, (inline) alignment metrology will also be performed on the alignment structures to yield the first layer shape data $ALs_1$.

**0066** Based on the above, it is possible to determine overlay as the difference between the second layer metrology and first layer metrology (e.g., according to the equation Eq1 for overlay OV above). However, it is also now possible to determine the following individually:

**0067** The alignment error, to more specifically the first layer alignment error, can be determined as the difference of the first layer shape data $ALs_1$ and first layer pattern displacement $PD_1$:

$$ALe_1 = ALs_1 - PD_1 \qquad Eq2$$

**0068** Exposure induced second layer pattern displacement $PD_{E2}$ can be determined as the difference of the second absolute position metric and first layer shape data $ALs_1$:

$$PD_{E2} = (ALi_2 + PD_{E2}) - ALs_1 \qquad Eq3$$

**0069** Process induced first layer pattern displacement $PD_{P1}$ can be determined as the difference between the first absolute position metric or first layer pattern displacement $PD_1$ and exposure induced first layer pattern displacement $PD_{E1}$:

$$PD_{P1} = PD_1 - PD_{E1} \qquad Eq4$$

which assumes that the exposure induced first layer pattern displacement $PD_{E1}$ has been determined when the first layer was measured (e.g., ADI, i.e., preprocessing/etch) with respect to a layer preceding the first layer. In this respect, it can be appreciated that the terms first layer and second layer are used to describe the relative relationship for these two layers, and one or more layers may have preceded the "first layer" (or intervened the first layer and second layer). As such, the methods and Equation Eq3 described in relation to the second layer may have been used in relation to the first layer to determine first layer pattern displacement $PD_{E1}$; e.g., from:

$$PD_{E1} = (ALi_1 + PD_{E1}) - ALs_0 \qquad Eq5$$

where $(ALi_1 + PD_{E1})$ is the measured absolute position metric for the first layer prior to exposure of the second layer (and prior to processing of this first layer) and $ALs_0$ is the measured shape (zero layer shape data) for the layer to which the first layer was aligned. Once again "zero layer" is used purely as a relative term to the "first layer", i.e., it is a layer exposed before the first layer. The term should not be understood to imply any absolute position in the stack; there may be any number of layers below this "zero layer" and/or between the zero layer and first layer.

**0070** Figure 5 illustrates the indirect alignment situation where the first layer L1 (with first layer structures 500) and second layer L2 (with second layer structures 510) are each aligned to an earlier layer L0 or zero layer comprising the alignment structures 520.

**0071** In addition to the parameters already described (overlay OV, exposure induced second layer pattern displacement $PD_{E2}$, second layer alignment induced shape $ALi_2$, first layer pattern displacement $PD_1$ (comprising exposure induced contribution $PD_{E1}$ and a processing induced contribution $PD_{P1}$), second layer measured alignment data $MA_2$ and first layer shape data $ALs_1$), the following parameters are also shown: first layer measured alignment data $MA_1$, first layer alignment induced shape $ALi_1$ and the second layer shape data $ALs_2$.

**0072** In a conventional indirect alignment, the relative overlay will yield the difference of the second absolute position metric $(ALi_2 + PD_{E2})$ and first absolute position metric $(ALi_1 + PD_1)$:

$$OV = (ALi_2 + PD_{E2}) - (ALi_1 + PD_1) \qquad Eq6$$

**0073** Conventional indirect alignment metrology will also yield the first layer shape data $ALs_i$, as measured for layer 1 from the marks 520 in layer 0, and second layer shape data $ALs_2$, as measured for layer 2 from the marks 520 in layer 0 (equal respectively to the first layer alignment induced shape $ALi_1$ and second layer alignment induced shape $ALi_2$).

**0074** Using relative overlay metrology it is not possible to determine the first layer pattern displacement $PD_1$, the exposure induced second layer pattern displacement $PD_{E2}$ or any (in this case relative) alignment error.

**0075** According to an embodiment, using absolute position metrology on each of the first layer structures 500 and second layer structures 510, the first layer metrology will yield first absolute position metric $ALi_1 + PD_1$ and the second layer metrology will yield second absolute position metric $ALi_2 + PD_{E2}$. As is conventional, (inline) alignment metrology will also be performed on the alignment structures to yield the first layer shape data $ALs_1$ and the second layer shape data $ALs_2$.

0076 Based on the above, it is possible to determine overlay as the difference between the second layer metrology and first layer metrology (e.g., according to equation Eq6 for overlay OV above). However, it is also now possible to determine the following individually.

0077 First layer pattern displacement $PD_1$ may be determined as the difference of the (measured) first absolute position metric and first layer shape data $ALs_1$:

$$PD_1 = (ALi_1 + PD_1) - ALs_1 \qquad Eq7$$

0078 Exposure induced second layer pattern displacement $PD_{E2}$ may be determined as the difference of the (measured) second absolute position metric and second layer shape data $ALs_2$:

$$PD_{E2} = (ALi_2 + PD_{E2}) - ALs_2 \qquad Eq8$$

0079 In addition, assuming that $PD_{E1}$ is known from the first layer metrology to an earlier layer (as has been described), then the first layer process contribution can be separated into the exposure induced and process induced contributions using Equation Eq4, in the same manner as the direct alignment example (i.e., such that process induced first layer pattern displacement $PD_{P1}$ can be determined).

0080 Furthermore the alignment error, or more specifically the relative alignment error $ALe_{2-1}$ (in this indirect alignment example any repeating alignment errors between the first layer and second layer will drop out of the overlay contribution), can be determined as the difference of said second layer shape data $ALs_2$ and said first absolute position metric $ALi_1 + PD_1$:

$$ALe_{2-1} = ALi_2 - (ALi_1 + PD_{P1}) \qquad Eq9$$

noting that $ALi_2$ and $ALi_1$ are known from Equations Eq7 and Eq8.

0081 The absolute measurements are a combination of different effects (alignment, processing and exposure). Separating these effects in the manner described enables better use of the acquired measurements. For example, an alignment recipe optimization may be performed which uses the alignment error $ALe_1$ or $ALe_{2-1}$ directly. For example, the alignment error may be minimized directly in an alignment model mapping (WAMM) or optical color weighing (OCW) method. OCW and the related OCIW (Optimal Color and Intensity Weighing) are in use or have been proposed to correct the mark position for process variation (e.g., mark asymmetry). These concepts are described in more detail in the publications US2019/0094721, WO 2017032534A2, US2020/0272061A1 and US2020/0081356A1, all of which are incorporated herein by reference). Another concept which could directly use the alignment error comprises MCLR (Multi-Color Lowest Residuals) described in more detail in PCT publication WO2022184405A1 which is incorporated herein by reference.

0082 Similarly lithographic apparatus (scanner) control can directly use the expose induced errors $PD_{E1}$, $PD_{E2}$... $PD_{EX}$ e.g., for exposure correction and/or calibration such as, for example: exposure corrections (stage positioning and/or lens control and/or dose control corrections), (modular) drift control, photonic model calibration and/or layer specific wafers-in-progress WIP correction.

0083 For example, in relative overlay measurements, slowly drifting hardware degradation is not visible since it will apply equally in both bottom and top layer and will cancel out (assuming insufficient time has passed between exposure of the layers). However, when a hardware component (for example) is changed between the layers, then an overlay penalty (WIP impact) in incurred. By being able to determine the absolute exposure induced displacement in each layer, there will no longer be any cancelation effect. This information may be used to track the hardware degradation. Further, consistency of the absolute fingerprint across different layers may be monitored to further identify scanner drift contributions.

0084 Processing apparatus (e.g., etcher or other processing device) control can directly use the process induced errors $PD_{D1}$, $PD_{D2}$... $PD_{DX}$. Co-optimization of lithographic apparatus and processing tool is also now possible based on the separately determined exposure process induced errors and process induced errors.

0085 The above embodiments are examples only and other variations are possible. While the structures measured to obtain the absolute position data may be respective overlay sub-structures of one or more overlay structures, other structures including product structures are possible. While the top layer metrology is described as being ADI metrology, post processing or after-etch inspection (AEI) is also possible (e.g., in addition to ADI metrology), to account for processing induced effects in the top layer.

0086 The alignment metrology, in addition to or as an alternative to standard inline alignment metrology e.g., using the lithographic apparatus's alignment sensor, may also be performed using a standalone alignment station. In such a case, the alignment metrology may be performed on other structures (e.g., overlay sub-structures such as bottom structures and/or functional product structure) in addition (or alternatively to) alignment structures.

0087 It can be appreciated that overlay may be measured in two directions of the substrate plane (conventionally referred to as X and Y) which do not necessarily have the same layer stack. As such, different alignment strategies (e.g., directly alignment vs indirect alignment) may apply to measurement of the same structures and/or same layers in different directions, or the same variation may be used in each of the two directions, but aligned to a different previous layer for either alignment or overlay.

0088 A second related embodiment will now be described, relating to the very first layer to be exposed on a substrate, herein referred to as the "foundation layer" to distinguish it from the more general use of the term "first layer" in the above description.

0089 When exposing this foundation layer, alignment structures are not yet present as they are part of the exposure image. Hence any thermal deformation and/or distortion of the substrate which occurs before and/or during this foundation layer exposure cannot be detected (and corrected) by conventional substrate alignment. Also, because this foundation layer is the very first layer exposed, overlay measurements are not possible immediately subsequent to its exposure as overlay metrology requires structures in two layers to quantify.

0090 One method for addressing one or both of these issues may be to use a (e.g., machine learning) algorithm to detect any potential thermal issue within the lithographic apparatus (e.g., scanner) prior to and/or during exposure. For example, such an algorithm may consider whether thermal conditions are within specification or are indicative of a potential significant impact on the substrate shape. For example, such an algorithm may use thermal trace signals from the wafer table core temperature sensors. However, there will always be a trade-off between false positives and negatives, meaning substrates which have a potential thermal issue might go unnoticed or non-issue substrates falsely detected. Furthermore, such detection will be only applicable to certain specific root causes, while being potentially unaware of others.

0091 It is proposed, therefore, to perform foundation layer metrology, e.g., using a standalone alignment station as has been described, on foundation layer structures in the foundation layer and using these to determine whether any measured deformation is correctable. The foundation layer structures may comprise, for example, alignment structures (alignment structures) and/or overlay sub-structures (bottom structures of overlay marks). The foundation layer structures may additionally or alternatively comprise functional product structure. A correctable deformation may be that for which it is possible to perform compensatory correction during exposure of one or more subsequent layers for a parameter of interest such as overly to be within a specification (e.g., indicative of a functioning device).

0092 The foundation layer metrology may be performed offline and therefore may comprise high-resolution or dense metrology to capture a high resolution fingerprint (spatial distribution of distortion over the substrate)

0093 Based on this determination, it can be determined whether the substrate should be reworked, for example when its deformation is determined to be non-correctable, or can be forwarded for next layer exposure. In the latter case, feed-forward corrections can be determined for this next layer exposure, from the foundation layer metrology.

0094 The decision to perform the foundation layer metrology on one or more substrates may be determined using a lithographic apparatus internal detection mechanism, which measures lithographic apparatus state data of the lithographic apparatus before/during foundation layer exposure. For example, this lithographic apparatus state data may describe a thermal state of the lithographic apparatus and/or substrate being exposed therein and may further comprise e.g., thermal trace signals. In such an embodiment, it may be that only substrates which do not exceed a certain "thermal" (or other lithographic apparatus signal) detection threshold are forwarded for foundation layer metrology. This can increase efficiency and decrease cost for implementing such an embodiment.

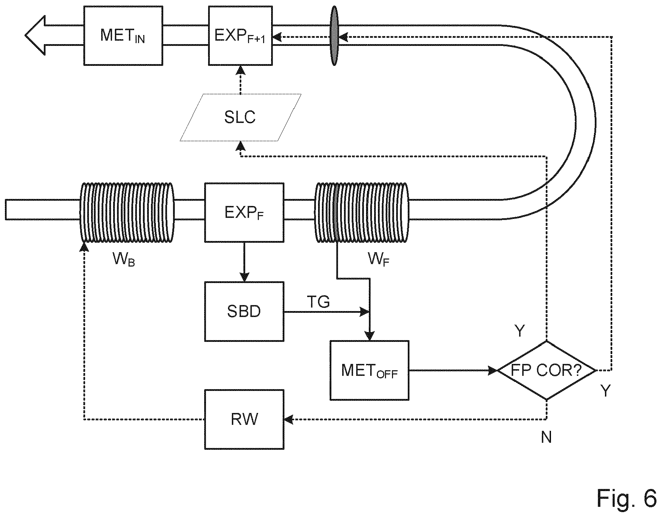

0095 Figure 6 is a flow diagram illustrating such a method. Bare substrates $W_B$, having not yet been subject to any exposures are exposed $EXP_F$ (e.g., within a lithographic apparatus), thereby exposing a foundation layer thereon. One or more of the resultant substrates $W_F$, comprising only a foundation layer, are selected for (e.g., offline) foundation layer metrology $MET_{OFF}$. Optionally, the decision to forward a substrate $W_F$ for foundation layer metrology $MET_{OFF}$ may be made based on a trigger TG generated by a signal based detection module SBD which monitors certain signals from the lithographic apparatus which may be indicative of a potential issue (e.g., a thermal issue) which may cause substrate distortion. Based on the foundation layer metrology, it is determined whether the measured fingerprint is correctable FP COR? (e.g., by lithographic apparatus actuation in the next/subsequent layers). If not determined to be correctable, the substrate may be reworked RW. If the fingerprint is correctable it may be forwarded for next (and all subsequent) layer exposure $EXP_{F+1}$ and, for example, conventional inline overlay metrology $MET_{IN}$ and/or overlay metrology as disclosed in the first main embodiment disclosed herein (e.g., in combination with Figures 4 and 5). In addition, a (e.g., single layer) correction SLC may be fed forward for correcting exposure of the next layer based on the measured fingerprint.

0096 The following clauses describe aspects of the first embodiment:

1. A method of metrology comprising:

obtaining a first absolute position metric of a first structure in a first layer on a substrate and a second absolute position metric of a second structure in a second layer of the substrate, the first layer being below the second layer; obtaining first layer shape data describing a shape of the first layer; and determining from said first layer shape data, first absolute position metric and said second absolute position metric one or more of: an exposure induced first layer pattern displacement describing a displacement error of said first structure resultant from exposure of the structure, an exposure induced second layer pattern displacement describing a displacement error of said second structure resultant from exposure of the structure, a process induced first layer pattern displacement describing a displacement error of said first structure resultant from processing of the structure and/or an alignment error describing an error in alignment data used to align the second layer to the first layer.

2. A method according to clause 1, comprising determining overlay from a difference of said first absolute position metric and second absolute position metric.

3. A method according to clause 1 or 2, wherein said second layer was aligned to said first layer prior to exposure of said second layer.

4. A method according to clause 3, comprising determining said exposure induced second layer pattern displacement from a difference of said second absolute position metric and said first layer shape data.

5. A method according to clause 3 or 4, comprising determining said alignment error as a difference of said first layer shape data and said first absolute position metric.

6. A method according to any of clauses 3 to 5, comprising:

determining an exposure induced first layer pattern displacement from a difference of a further absolute position metric for the first structure in the first layer as measured prior to exposure of the second layer and zero layer shape data relating to the layer to which said first layer was aligned; and
determining said process induced first layer pattern displacement as the difference between the first absolute position metric and the exposure induced first layer pattern displacement.

7. A method according to clause 1 or 2, wherein said second layer and said first layer where each aligned to a common zero layer exposed prior to said second layer and said first layer; and said method further comprises:
obtaining second layer shape data describing a shape of the second layer.

8. A method according to clause 7, comprising determining a first layer pattern displacement describing a displacement error of said first structure as a difference between said first absolute position metric and said first layer shape data.

9. A method according to clause 8, comprising:

determining an exposure induced first layer pattern displacement from a difference of a further absolute position metric for the first structure in the first layer as measured prior to exposure of the second layer and zero layer shape data relating to the layer to which said first layer was aligned; and
determining said process induced first layer pattern displacement as the difference between the first layer pattern displacement and the exposure induced first layer pattern displacement.

10. A method according to any of clause 7 to 9, comprising determining said exposure induced second layer pattern displacement as a difference between said second absolute position metric and said second layer shape data.

11. A method according to any of clauses 7 to 10, comprising determining said alignment error as the difference of said second layer shape data and said first absolute position metric.

12. A method according to any of clauses 7 to 11, comprising determining said second layer shape data from second layer alignment data.

13. A method according to any preceding clause, comprising determining said first layer shape data from first layer alignment data.

14. A method according to any preceding clause, comprising determining an exposure correction, optimization and/or calibration for implementation within a lithographic apparatus using said exposure induced first layer pattern displacement and/or said exposure induced second layer pattern displacement.

15. A method according to clause 14, wherein said exposure correction, optimization and/or calibration comprises one or more of: stage positioning and/or lens control corrections, drift control, photonic model calibration and/or layer specific wafers-in-progress correction.

16. A method according to any preceding clause, comprising determining a processing correction, optimization and/or calibration for implementation within a processing apparatus using said process induced first layer pattern displacement.

17. A method according to any preceding clause, comprising determining an alignment correction optimization and/or calibration using said alignment error.

18. A method according to any preceding clause, comprising measuring said first absolute position metric and said second absolute position metric.

19. A method according to clause 18, wherein said first absolute position metric and said second absolute position metric are measured using a standalone alignment station or scanning electron microscope.

20. A computer program comprising program instructions operable to perform the method of any preceding clause, when run on a suitable apparatus.

21. A non-transient computer program carrier comprising the computer program of clause 20.

22. A processing arrangement comprising:

a computer program carrier comprising the computer program of clause 21; and
a processor operable to run said computer program.

22. A metrology apparatus comprising the processing arrangement of clause 22.

23. A metrology apparatus as clauseed in clause 22, comprising:

a standalone alignment station or an electron microscope.

0097 The following clauses describe aspects of the second embodiment:

1. A method of metrology comprising:

obtaining foundation layer metrology data relating to a substrate on which only a foundation layer has been exposed, the foundation layer comprising a very first layer exposed on the substrate; the foundation layer metrology data describing a deformation of the substrate; and determining whether the deformation described by said foundation layer metrology data is correctable, in that it is possible to perform compensatory correction during exposure of one or more subsequent layers for a parameter of interest to be within a specification.

2. A method according to clause 1, comprising forwarding the substrate for rework if said distortion is not determined to be correctable.

3. A method according to clause 1 or 2, comprising determining a feedforward correction for exposure of one or more subsequent layers from the foundation layer metrology data, which corrects for said distortion.

4. A method according to any preceding clause, wherein the foundation layer metrology data has been obtained from measurement of structures in said foundation layer, the structures comprising one or more of alignment marks, overlay sub-structures and/or functional product structure.

5. A method according to any preceding clause, wherein the foundation layer metrology data has been obtained from measurement of at least overlay sub-structures.

6. A method according to any preceding clause, comprising deciding to perform foundation layer metrology on a particular substrate to obtain said foundation layer metrology data based on lithographic apparatus state data describing a state within the lithographic apparatus and/or substrate being exposed therein.

7. A method according to clause 6, wherein said lithographic apparatus state data describes a thermal state of the lithographic apparatus and/or substrate being exposed therein.

8. A method according to any preceding clause, comprising performing foundation layer metrology to obtain said foundation layer metrology data.

9. A method according to clause 8, wherein said foundation layer metrology is performed offline.

10. A method according to clause 8 or 9, comprising performing said foundation layer metrology on a standalone alignment station.

11. A computer program comprising program instructions operable to perform the method of any of clauses 1 to 7, when run on a suitable apparatus.

12. A metrology device operable to perform the method of any of clauses 8 or 9.

13. A metrology device according to clause 12 comprising a standalone alignment station or an electron microscope.

0098 In association with the hardware of the lithographic apparatus and the lithocell LC, an embodiment may include a computer program containing one or more sequences of machine-readable instructions for causing the processors of the lithographic manufacturing system to implement methods of model mapping and control as described above. This computer program may be executed for example in a separate computer system employed for the image calculation/control process. Alternatively, the calculation steps may be wholly or partly performed within a processor a metrology tool, and/or the control unit LACU and/or supervisory control system SCS of Figures 1 and 2. There may also be provided a data storage medium (e.g., semiconductor memory, magnetic or optical disk) having such a computer program stored therein in non-transient form.

0099 Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

00100 The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

00101 The breadth and scope of the present invention should not be limited by any of the above-described exemplary embodiments, but should be defined only in accordance with the following claims and their equivalents.

**Claims**

1.  A method of metrology comprising:

    obtaining a first absolute position metric of a first structure in a first layer on a substrate and a second absolute position metric of a second structure in a second layer of the substrate, the first layer being below the second layer;
    obtaining first layer shape data describing a shape of the first layer; and
    determining from said first layer shape data, first absolute position metric and said second absolute position metric one or more of: an exposure induced first layer pattern displacement describing a displacement error of said first structure resultant from exposure of the structure, an exposure induced second layer pattern displacement describing a displacement error of said second structure resultant from exposure of the structure, a process induced first layer pattern displacement describing a displacement error of said first structure resultant from processing of the structure and/or an alignment error describing an error in alignment data used to align the second layer to the first layer.

2.  A method according to claim 1, comprising determining overlay from a difference of said first absolute position metric and second absolute position metric.

3.  A method according to claim 1 or 2, wherein said second layer was aligned to said first layer prior to exposure of said second layer.

4.  A method according to claim 3, comprising determining said exposure induced second layer pattern displacement from a difference of said second absolute position metric and said first layer shape data.

5.  A method according to claim 3 or 4, comprising determining said alignment error as a difference of said first layer shape data and said first absolute position metric.

6.  A method according to any of claims 3 to 5, comprising:

    determining an exposure induced first layer pattern displacement from a difference of a further absolute position metric for the first structure in the first layer as measured prior to exposure of the second layer and zero layer shape data relating to the layer to which said first layer was aligned; and
    determining said process induced first layer pattern displacement as the difference between the first absolute position metric and the exposure induced first layer pattern displacement.

7.  A method according to claim 1 or 2, wherein said second layer and said first layer where each aligned to a common zero layer exposed prior to said second layer and said first layer; and said method further comprises:
    obtaining second layer shape data describing a shape of the second layer.

8.  A method according to claim 7, comprising determining a first layer pattern displacement describing a displacement error of said first structure as a difference between said first absolute position metric and said first layer shape data.

9.  A method according to claim 8, comprising:

    determining an exposure induced first layer pattern displacement from a difference of a further absolute position metric for the first structure in the first layer as measured prior to exposure of the second layer and zero layer shape data relating to the layer to which said first layer was aligned; and
    determining said process induced first layer pattern displacement as the difference between the first layer pattern displacement and the exposure induced first layer pattern displacement.

10. A method according to any of claim 7 to 9, comprising determining said exposure induced second layer pattern displacement as a difference between said second absolute position metric and said second layer shape data.

11. A method according to any of claims 7 to 10, comprising determining said alignment error as the difference of said second layer shape data and said first absolute position metric.

**12.** A method according to any preceding claim, comprising determining one or more of:

an exposure correction, optimization and/or calibration for implementation within a lithographic apparatus using said exposure induced first layer pattern displacement and/or said exposure induced second layer pattern displacement;

a processing correction, optimization and/or calibration for implementation within a processing apparatus using said process induced first layer pattern displacement; and/or

an alignment correction optimization and/or calibration using said alignment error.

**13.** A method according to any preceding claim, comprising measuring said first absolute position metric and said second absolute position metric.

**14.** A computer program comprising program instructions operable to perform the method of any preceding claim, when run on a suitable apparatus.

**15.** A metrology apparatus comprising:

a computer program carrier comprising the computer program of claim 14; and

a processor operable to run said computer program.

Fig. 1

Fig. 2

Fig. 3

Fig. 4

Fig. 5

Fig. 6

Europäisches
Patentamt

European
Patent Office

Office européen
des brevets

# EUROPEAN SEARCH REPORT

Application Number

EP 23 18 2989

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 506 012 A1 (NIKON CORP [JP]) 3 July 2019 (2019-07-03) | 1-3, 12-15 | INV. G03F7/20 |
| A | * paragraphs [0242] - [0268]; figure 15 * | 4-11 | |
| A | US 2022/050384 A1 (DEVILLIERS ANTON J [US]) 17 February 2022 (2022-02-17) * paragraphs [0039], [0072] * | 1-15 | |
| A,D | LEE JAEIL ET AL: "Absolute alignment measurement of underlayer and overlayer of diffraction-based overlay mark by image-based alignment metrology system", 20230427, vol. 12496, 27 April 2023 (2023-04-27), pages 124962F-124962F, XP060180095, ISSN: 0277-786X, DOI: 10.1117/12.2657656 ISBN: 978-1-5106-6099-1 * the whole document * | 1-15 | |

**TECHNICAL FIELDS SEARCHED (IPC)**

G03F

The present search report has been drawn up for all claims

| Place of search | Date of completion of the search | Examiner |
|---|---|---|
| Munich | 18 December 2023 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 2989

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2023

| Patent document cited in search report | | | Publication date | Patent family member(s) | | Publication date |
|---|---|---|---|---|---|---|
| EP 3506012 | A1 | 03-07-2019 | | CN | 109863457 A | 07-06-2019 |
| | | | | EP | 3506012 A1 | 03-07-2019 |
| | | | | JP | 2021121872 A | 26-08-2021 |
| | | | | JP | 2023022066 A | 14-02-2023 |
| | | | | JP | WO2018038071 A1 | 18-07-2019 |
| | | | | KR | 20190040279 A | 17-04-2019 |
| | | | | TW | 201826047 A | 16-07-2018 |
| | | | | TW | 202316205 A | 16-04-2023 |
| | | | | US | 2019257647 A1 | 22-08-2019 |
| | | | | US | 2022155062 A1 | 19-05-2022 |
| | | | | WO | 2018038071 A1 | 01-03-2018 |
| US 2022050384 | A1 | 17-02-2022 | | CN | 116057473 A | 02-05-2023 |
| | | | | CN | 116113886 A | 12-05-2023 |
| | | | | JP | 2023540683 A | 26-09-2023 |
| | | | | JP | 2023540684 A | 26-09-2023 |
| | | | | KR | 20230050337 A | 14-04-2023 |
| | | | | KR | 20230052877 A | 20-04-2023 |
| | | | | KR | 20230052878 A | 20-04-2023 |
| | | | | KR | 20230052882 A | 20-04-2023 |
| | | | | KR | 20230052883 A | 20-04-2023 |
| | | | | KR | 20230052888 A | 20-04-2023 |
| | | | | TW | 202221819 A | 01-06-2022 |
| | | | | TW | 202223533 A | 16-06-2022 |
| | | | | TW | 202223555 A | 16-06-2022 |
| | | | | TW | 202225851 A | 01-07-2022 |
| | | | | TW | 202225864 A | 01-07-2022 |
| | | | | TW | 202225865 A | 01-07-2022 |
| | | | | US | 2022050384 A1 | 17-02-2022 |
| | | | | US | 2022050385 A1 | 17-02-2022 |
| | | | | US | 2022050386 A1 | 17-02-2022 |
| | | | | US | 2022050388 A1 | 17-02-2022 |
| | | | | US | 2022050393 A1 | 17-02-2022 |
| | | | | US | 2022051951 A1 | 17-02-2022 |
| | | | | WO | 2022040201 A1 | 24-02-2022 |
| | | | | WO | 2022040207 A1 | 24-02-2022 |
| | | | | WO | 2022040211 A1 | 24-02-2022 |
| | | | | WO | 2022040221 A1 | 24-02-2022 |
| | | | | WO | 2022040226 A1 | 24-02-2022 |
| | | | | WO | 2022040228 A1 | 24-02-2022 |

EPO FORM P0459

For more details about this annex : see Official Journal of the European Patent Office, No. 12/82

**EP 4 488 757 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006066855 A1
- US 2011102753 A1
- US 20120044470 A
- WO 2019001871 A
- WO 2017060054 A
- US 20190094721 A
- WO 2017032534 A2
- US 20200272061 A1
- US 20200081356 A1
- WO 2022184405 A1

### Non-patent literature cited in the description

- **LEE et al.** Absolute alignment measurement of underlayer and overlayer of diffraction-based overlay mark by image-based alignment metrology system. *SPIE Advanced Lithography*, 2023